# EUROPEAN PATENT APPLICATION

(11) **EP 3 839 629 A1**
(43) Date of publication of application: **23.06.2021**
(21) Application number: 19306677.6
(22) Date of filing: 18.12.2019
(51) Int. Cl.: G03F 7/028, G02C 7/00

(54) **RADIATION CURABLE COATING COMPOSITION, METHOD FOR COATING SUBSTRATE, AND SUBSTRATE HAVING CURED COMPOSITION**

(71) Applicant: ESSILOR INTERNATIONAL, 94220 Charenton-Le-Pont (FR)
(72) Inventor: VALERI, Robert, Dallas, TX Texas 75234 (US)
(74) Representative: Jacobacci Coralis Harle

(57) **Abstract**

A coating composition, including an epoxyalkoxysilane, a photoinitiator, a colorant, and an acrylate. A method for coating an edge of a substrate, including applying the coating composition and curing the coating composition so that a coating is formed on the edge of the substrate. A lens, including: a substrate having a first main surface, a second main surface, and an edge connecting the first main surface and the second main surface; and a coating formed on the edge of the substrate and obtained by curing the coating composition.

## Description

### BACKGROUND

The present disclosure relates to a radiation curable coating composition, to a method for coating a substrate, and to a substrate having a cured composition.

Ophthalmic lenses, especially ophthalmic lenses for correction of myopia, often display rings in the periphery of the lens. Those rings, called myopia rings, are produced due to internal reflections of light. Those myopia rings are not cosmetically appealing as they are visible from the side of the wearer and accentuate the thickness of the lenses.

Several attempts have been made to coat the edges of myopia lenses with an opaque coating to reduce or even eliminate these myopia rings. Those coatings may make the lenses appear thinner than the actual thickness. Those coatings may also be used to coat the edges of lenses for purposes other than reducing or eliminating myopic rings, such as sealing the edges and coloring the edges for aesthetic purposes.

To effectively coat the edges of ophthalmic lenses and mask myopia rings, and/or to improve appearance of the lenses, there is a need for a fast curing, stable coating composition that exhibits good adhesion to ophthalmic lens substrates upon curing. The cured coating desirably has good adhesion to various ophthalmic lens substrates, including thermoset substrates and thermoplastic substrates. Also, it is desirable that the cured coating is colorfast and resistant to various solvents so that colorants do not leach out from the cured coating upon exposure to regular cleaning solutions used on ophthalmic lenses.

### SUMMARY

One aspect of the present embodiments is related to a fast curing composition that can form an opaque coating having robust adhesion to multiple substrates. The coating composition includes, in particular, an epoxyalkoxysilane and an acrylate so that the cured coating exhibits good adhesion to thermosets and thermoplastics. Epoxyalkoxysilanes and acrylates are compatible with, and can react with, pigments such as carbon black to make opaque coatings when cured. The coating composition is a single-component (or "1K") composition that does not require pre-mixing of separate components just prior to use. The cured coating is more stable and has a longer pot-life and shelf-life as compared to conventional two-components (or "2K") tinted coatings or paints having two components that should be mixed together immediately prior to use. The cured coating exhibits good adhesion to multiple ophthalmic lens substrates including both thermosets and thermoplastics. The coating composition is easy to apply to the lens edge, and is quickly curable by radiation.

In one aspect, the coating composition includes: an epoxyalkoxysilane; a photoinitiator; a colorant; and an acrylate. The epoxyalkoxysilane may include glycidoxypropyltrimethoxysilane. The photoinitiator may include a cationic photoinitiator and a free radical photoinitiator. The colorant may include carbon black. The acrylate may include dipentaerythritolpentaacrylate. The coating composition may further include a vinyl based monomer. The vinyl based monomer is a compound other than the acrylate and may include vinyltrimethoxysilane. The coating composition may be free of a solvent.

One aspect of the present embodiments is related to a method for coating an edge of a substrate, including applying the coating composition described above on an edge of a substrate, and curing the coating composition so that a coating is formed on the edge of the substrate. The edge is a region connecting a first main surface and a second main surface of the substrate. The substrate may be an organic ophthalmic lens, and may include a thermoplastic material or a thermoset material. The substrate may include polycarbonate. The substrate may have a refractive index of from 1.50 to 1.74.

Another aspect of the present embodiments is related to a lens including a substrate having a first main surface, a second main surface, and an edge connecting the first main surface and the second main surface; and a coating formed on the edge of the substrate and obtained by curing the coating composition described above. The coating may be opaque and may not be formed on the first and second main surfaces.

### DETAILED DESCRIPTION OF THE EMBODIMENTS

Various embodiments of the present disclosure will now be described below.

A first embodiment is related to a curable coating composition, including at least one epoxyalkoxysilane, at least one photoinitiator, at least one colorant, and at least one acrylate.

The epoxyalkoxysilane in the curable coating composition may be any compound having at least one epoxy group and at least one alkoxysilane group in one molecule. The epoxyalkoxysilane may be a monofunctional alkoxysilane compound having one alkoxysilane group, a bifunctional alkoxysilane compound having two alkoxysilane groups, or a trifunctional alkoxysilane compound having three alkoxysilane groups, and is preferably a trifunctional alkoxysilane compound.

Examples of the alkoxysilane group in the epoxyalkoxysilane include, but are not limited to, a trimethoxysilane group and a triethoxysilane group. The alkoxysilane group in the epoxyalkoxysilane is preferably a trimethoxysilane group.

Preferred examples of the epoxyalkoxysilane include, but are not limited to, 2-(3,4-epoxycyclohexy)ethyltriethoxysilane, 2-(3,4-epoxycyclohexylethyltrimethoxysilane, 5,6-epoxyhexyltriethoxysilane, 2-(3,4-epoxycyclohexl)ethylmethyldiethoxysilane, (3-glycidoxypropyl)methyldiethoxysilane, (3-glycidoxypropyl)methyldiethoxysilane, (3-glycidoxypropyldimethyldimethoxysilane, (3-glydidoxypropyl)dimethoxysilane, (3-glycidoxypropyl)trimethoxysilane and (3-glycidoxypropyl)triethoxysilane.

When cured, the epoxyalkoxysilane may provide strong adhesion to thermoset substrates. Although not limited in any way, it is considered that hydroxyl groups formed from the alkoxysilane group(s) of the epoxyalkoxysilane, upon irradiation, react with each other and with the hydroxyl groups on the thermoset substrates to form a cross-linked matrix, and this cross-linked matrix achieves strong adhesion to the thermoset substrates.

Preferably, the curable coating composition includes glycidoxypropyltrimethoxysilane.

The amount of the epoxyalkoxysilane included in the curable coating composition may be from 20 to 75% by mass, preferably from 30 to 60% by mass, more preferably from 35 to 45% by mass, and particularly preferably from 38 to 43% by mass, and including all ranges and subranges therebetween.

The colorant in the curable coating composition may be any dyes and any pigments that are suitable for coloring a curable coating composition. Preferably, the dyes and pigments are not toxic and harmful to humans, and particularly preferably the dyes and pigments in the curable coating composition are compounds that are suitably used in manufacturing eyeglasses. When the curable coating composition is used to manufacture eyeglasses, the color of dyes and pigments may be selected depending on the desired color that may match the color of the lenses or frames.

In one exemplary embodiment, the colorant is a compound that provides a black color to a cured coating. Examples of such colorant include, but are not limited to, carbon black. When carbon black is used, the curable coating composition may be black, and an opaque black coating may be formed upon curing the coating composition.

Carbon black may be in any grade and may have any particle size. Although not limited in any way, carbon blacks with a relatively small particle size may be preferably used as more UV light can penetrate toward the bottom of a cured coating obtained by curing the coating composition.

Carbon black having at least one hydroxyl (-OH) group on its surface may be preferably used in the curable coating composition. For example, commercially available REGAL® 400 Carbon Black (Furnace Black), sold by Cabot Corporation, may be used. REGAL® 400 Carbon Black has on its surface hydroxyl groups. Although not limited in any way, it is considered that the surface hydroxyl groups of the carbon black, such as REGAL® 400 Carbon Black, react with the hydroxyl groups in the silanol groups generated from the alkoxysilane group(s) of the epoxyalkoxysilane upon irradiation in the presence of a photoinitiator so that the carbon black particles are bound to the coating matrix.

In one exemplary embodiment, the colorant includes titanium dioxide (TiO₂). TiO₂ may be used alone or in combination with other dye(s) and pigment(s), such as carbon black.

The curable coating composition may include the colorant in an amount sufficient to provide a desirable color to a cured coating. In addition, the amount of the colorant may be sufficient to prepare an opaque cured coating.

The amount of colorant included in the curable coating composition may be 5 to 30 % by mass, preferably 10 to 25% by mass, more preferably from 15 to 20% by mass, and most preferably 15 to 19% by mass, and including all ranges and subranges therebetween. If the curable coating composition includes a particularly large amount of the colorant, viscosity of the coating composition may become too high, depending on the other components and their amounts of the curable coating composition. Also, the excessive colorant may leach out from a cured coating when the cured coating is exposed to a solvent.

The acrylate in the curable coating composition may be any acrylate monomers and acrylate polymers having at least one vinyl group. For example, the acrylate may be a monofunctional acrylate monomer having one acrylate group, a difunctional acrylate monomer having two acrylate groups, a trifunctional acrylate monomer having three acrylate groups, a tetrafuctional acrylate having four acrylate groups, a pentafunctional acrylate, having five acrylate groups, or even a hexafunctional acrylate having six acrylate groups. The acrylate may also be an acrylate oligomer such as a urethane acrylate, a polyester acrylate, an epoxy acrylate, or an amine modified acrylate.

Examples of acrylate monomers include, but are not limited to, phenoxyethyl acrylate, 1,6-hexanediol diacrylate, 1,4-butanediol diacrylate, trimethylolpropanetriacrylate, ethoxylated pentaerythritol tetraacrylate, and dipentaerythritol pentaacrylate. Examples of urethane acrylate oligomers include, but are not limited to, aromatic urethane oligomers, aliphatic urethane acrylates, and blends of urethane acrylate oligomers with acrylate monomers.

The acrylate may be (meth)acrylate. As used herein, the term "meth" associated to the term acrylate, means that relating to a molecule or to a family of molecules the acrylate function H₂C=CHC(O)- could have a methyl group at α position of the ethylene function like H₂C=C(CH₃)C(O)-.

(Meth)acrylates can be monofunctional, difunctional, trifunctional, tetrafunctional, pentafunctional, and even hexafunctional. Although not limited in any way, typically, the higher the functionality, the greater is the crosslink density. (Meth)acrylates may have slower curing than acrylates.

Examples of the two, three, four or six (meth)acrylic functional groups include, but are not limited to, pentaerythritol triacrylate, pentaerythritol tetraacrylate, tetraethyleneglycol diacrylate, diethyleneglycol diacrylate, triethyleneglycol diacrylate, 1,6-hexanediol di(meth)acrylate, tripropylene glycol diacrylate, dipropyleneglycol diacrylate, ethyleneglycol dimethacrylate, trimethylolethane triacrylate, trimethylolmethane triacrylate, trimethylolpropane triacrylate, trimethylolpropane trimethacrylate, 1,2,4-butanetriol trimethacrylate, tris(2-hydroxyethyl) isocyanurate triacrylate, di-trimetholpropane tetraacrylate, ethoxylated pentaerythritol tetraacrylate, triphenylolmethane triacrylate, trisphenol triacrylate, tetraphenylol ethane triacrylate, 1,2,6-hexanetriol triacrylate, glycerol triacrylate, diglycerol triacrylate, glycerol ethoxylate triacrylate, ethylene glycol diacrylate, 1,4-butanediol diacrylate, 1,4-butanediol dimethacrylate, neopentyl glycol diacrylate, cyclohexanedimethanol diacrylate, dipropylene glycol diacrylate, polypropylene glycol diacrylate, dipentaerythritol hexaacrylate, polyester hexaacrylate, sorbitol hexaacrylate, and fatty acid-modified polyester hexaacrylate.

Particularly preferred examples of an acrylate include dipentaerythritolpehtaacrylate represented by the following formula (1):

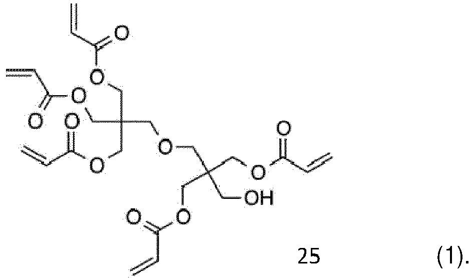

When the acrylate is cured in the presence of a free radical photoinitiator, the vinyl groups in the molecules of acrylate may react with each other to form a crosslinked structure. This crosslinked structure may provide strong adhesion to thermoplastics, such as polycarbonate. Thus, by including the epoxyalkoxysilane that may provide strong adhesion to thermoset substrates and the acrylate that may provide strong adhesion to thermoplastic substrates, a hybrid epoxy/acrylate coating having excellent adhesion to various substrates may be formed.

Preferably, the acrylate has a high cross-link density when cured. For example, dipentaerythritolpentaacrylate may be used as the acrylate.

Preferably, the curable coating composition includes dipentaerythritolpentaacrylate.

The amount of acrylate included in the curable coating composition may be 3 to 30% by mass, preferably 5 to 20% by mass, more preferably 7 to 15% by mass, and most preferably 8 to 10% by mass, and including all ranges and subranges therebetween.

The photoinitiator in the curable coating composition is not particularly limited, and any compounds that create reactive species, such as free radicals, cations, or anions, when exposed to radiation, may be used. The photoinitiator is capable of initiating or catalyzing polymerization of at least one of the epoxyalkoxysilane and the acrylate in the curable coating composition. Preferably, the photoinitiator is a compound capable of initiating or catalyzing polymerization of at least one of the epoxyalkoxysilane and the acrylate upon irradiation with ultraviolet (UV).

In one exemplary embodiment, the curable coating composition includes a cationic photoinitiator and a free radical photoinitiator. A cationic photoinitiator may be any compounds that generate a cation when exposed to radiation, for example UV radiation. A free radical photoinitiator may be any compounds that generate a free radical when exposed to radiation, for example UV radiation.

Although not limited in any way, when a cationic photoinitiator is included in the curable coating composition, the cationic photoinitiator generates an acid (cation) upon photolysis. The cationic photoinitiator can open the epoxy ring of the epoxyalkoxysilane. The acid (cation) generated by photolysis of the cationic photoinitiator can react with water vapor in the air, or atmospheric moisture, and promote hydrolysis of the alkoxysilane groups of the epoxyalkoxysilane to form silanols. Condensation of the hydroxyl groups of the resulting silanols may occur with the heat generated during the UV cure. The silanols may react with one another, and with hydroxyl groups on the substrate surface, to form a highly crosslinked matrix that may exhibit excellent adhesion to the substrate and solvent resistance.

The cationic photoinitiator is not limited, as long as it is capable of generating an acid (cation) upon photolysis. Examples of the cationic photoinitiator include, but are not limited to, triarylsulfonium salts, such as triarylsulfonium hexafluoroantimonate and triarylsulfonium hexafluorophosphate, aryldiazonium salts, diaryliodonium salts, and triarylselenium salts.

When a free radical photoinitiator is included in the curable coating composition, the free radical photoinitiator generates a free radical upon photolysis. The free radical may be utilized to polymerize the acrylate in the curable coating composition.

The free radical photoinitiator is not limited, as long as it is capable of generating a free radical upon photolysis. Examples of the free radical photoinitiator include, but are not limited to, benzophenone, methyl benzophenone, xanthones, acylphosphine oxide type such as 2,4,6,-trimethylbenzoyldiphenyl phosphine oxide, 2,4,6,-trimethylbenzoylethoxydiphenyl phosphine oxide, bisacylphosphine oxides (BAPO), benzoin and benzoin alkyl ethers like benzoin methyl ether, benzoin isopropyl ether.

Examples of the free radical photoinitiator also include: haloalkylated aromatic ketones such as chloromethylbenzophenones ; some benzoin ethers such as benzoin methyl ether, benzoin ethyl ether, benzoin isopropyl ether, benzoin isobutylether ether, benzoin, benzyl, benzyl disulfide; dialkoxyacetophenones such as diethoxyacetophenone and α,α-dimethoxy-α-phenylacetophenone , benzylideneacetophenone, benzophenoen, acethophenone,; hydroxy ketones such as (1-[4-(2-hydroxyethoxy)-phenyl]-2-hydroxy-2-methyl-1-propan- 1-one) (Irgacure® 2959 from CIBA), 2,2-di-sec-butoxyacethophenone, 2,2-diethoxy-2-phenylacetophenone, 1-hydroxy-cyclohexyl-phenyl-ketone (Irgacure® 184 from CIBA) and 2-hydroxy-2-methyl-1-phenylpropan-1-one (such as Darocur® 1173 sold by CIBA) ; alpha amino ketones, particularly those containing a benzoyl moiety, otherwise called alpha-amino acetophenones, for example 2-methyl 1-[4-phenyl]-2-morpholinopropan-1-one (Irgacure® 907 from CIBA), (2-benzyl-2-dimethyl amino-1-(4-morpholinophenyl)-butan-1-one (Irgacure® 369 from CIBA); monoacyl and bisacyl phosphine oxides and sulphides, such as phenylbis(2,4,6-trimethylbenzoyl)-phosphine oxide (Irgacure® 819 sold by CIBA); triacyl phosphine oxides ; and mixtures thereof.

The commercially available product listed above, such as Irgacure® 2959, Irgacure® 184, Darocur® 1173, and Irgacure® 819, are examples of each of the free radical photoinitiators, and the free radical photoinitiator is not limited to those particular products.

The amount of photoinitiator in the curable coating composition may be determined based on the amount of colorant, in particular the amount of carbon black, since carbon black may absorb light at all wavelengths and the photoinitiator may compete for the photons.

The amount of photoinitiator in the curable coating composition may also be determined based on the amount of epoxyalkoxysilane and the amount of acrylate.

In particular, the amount of cationic photoinitiator in the curable coating composition may be determined based on the amount of the epoxyalkoxysilane to adequately cure the epoxyalkoxysilane upon irradiation. For example, the amount of cationic photoinitiator may be at least 6% by mass, preferably at least 8% by mass, more preferably at least 9% by mass, based on 100% by mass of the amount of epoxyalkoxysilane. If the amount of cationic photoinitiator is not sufficient, the curable coating composition may not be sufficiently cured upon irradiation to retain the colorant in the cured coating, and the cured coating may cause leaching of the colorant when the cured coating is exposed to a solvent. Preferably, the curable coating composition includes 6 to 15% by mass, preferably 8 to 14% by mass, more preferably 9 to 13% by mass, of cationic photoinitiators in total, based on 100% by mass of the amount of the epoxyalkoxysilane, and including all ranges and subranges therebetween.

The total amount of free radical photoinitiators in the curable coating composition may be determined based on the amount of acrylate to adequately cure the acrylate upon irradiation. If the amount of free radical photoinitiator is not sufficient, the curable coating composition may not be sufficiently cured upon irradiation to retain the colorant in the cured coating, and the cured coating may cause leaching of the colorant when the cured coating is exposed to a solvent.

The amount of photoinitiator included in the curable coating composition may be 5 to 15% by mass, preferably 6 to 10% by mass, and including all ranges and subranges therebetween. When the curable coating composition includes a cationic photoinitiator and a free radical photoinitiator, the amount of cationic photoinitiator may be 4 to 12% by mass, preferably 5 to 10% by mass, and including all ranges and subranges therebetween, and the amount of free radical photoinitiator may be 0.1 to 5% by mass, preferably 2 to 5% by mass, and including all ranges and subranges therebetween.

The curable coating composition may further include a vinyl based monomer. As used herein, the "vinyl based monomer" means a monomer having at least one vinyl group, and does not include the acrylate disclosed above.

The vinyl based monomer may provide rigidity to the cured coating. When a cured coating is formed on a lens for eyeglasses, the vinyl based monomer may provide rigidity to the cured coating so that the cured coating can resist chipping when the lens having the cured coating is mounted on and/or unmounted from a frame.

Preferably, the vinyl based monomer has at least one alkoxysilane group. The alkoxysilane group may be the same as or different from the alkoxysilane group of the epoxyalkoxysilane. The vinyl based monomer having an alkoxysilane group may form a highly crosslinked structure when cured. While not limited in any way, it is considered that, when cured, the alkoxysilane group of the vinyl based monomer and the alkoxysilane group of the epoxyalkoxysilane form silanol groups, and the hydroxyl groups of the formed silanol groups react with each other to form a crosslinked structure.

Examples of the vinyl based monomer having an alkoxysilane group include, but are not limited to, vinyltrimethoxysilane vinyltriethoxysilane, vinytris(2-methoxyethoxy)silane, vinyltrisisopropoxy, vinyldimethylethoxysilane, vinylmethyldimethoxysilane, and vinylmethyldiethoxysilane. Preferably, the curable coating composition includes vinyltrimethoxysilane represented by the following formula (2):

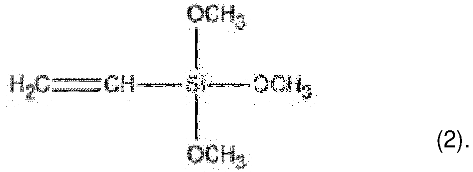

The amount of vinyl based monomer included in the curable coating composition may be 9 to 30% by mass, preferably 15 to 28% by mass, more preferably 20 to 25% by mass, and including all ranges and subranges therebetween.

When the curable coating composition includes the vinyl based monomer, the amount of photoinitiator may be determined so that the epoxyalkoxysilane, the acrylate, and the vinyl based monomer are sufficiently cured upon irradiation. Also, when the curable coating composition includes the vinyl based monomer having an alkoxysilane group, the amount of cationic photoinitiator may be determined so that the alkoxysilane groups in the epoxyalkoxysilane and the alkoxysilane group in the vinyl based monomer are sufficiently cured to form a crosskinked structure upon irradiation.

The curable coating composition may further include any components that may be generally used in a coating composition, in particular a coating composition for manufacturing eyeglasses.

The curable coating composition may include or may be free of a solvent. For example, the curable coating composition may include any solvent that can commonly be used in a curable coating composition. Also, for example, the curable coating composition does not include any solvent that may reduce viscosity of a composition consisting of the epoxyalkoxysilane, the acrylate, the colorant, the photoinitiator, and optionally the vinyl based monomer, without changing other properties of the composition. For example, the curable coating composition may include or may be free of commonly used solvents such as water, alcohols, ketones, esters, glycol ethers, and other hydrocarbon solvents. Examples of alcohols include, but are not limited to, methanol, ethanol, n-propanol, isopropanol, butanol, and 2-butanol. Examples of ketones include, but are not limited to, methylethylketone, acetone, and butanone. Examples of glycol ethers include, but are not limited to, ethyleneglycolmonomethylether, ethyleneglycolmonoethyl ether, and dipropyleneglycol methylether. In one preferred embodiment, the curable coating composition is free of a solvent, in particular the solvents listed above.

The curable coating composition may have a viscosity of 10-50 cps, preferably 15-45 cps, more preferably 20-40 cps, and including all ranges and subranges therebetween, when measured at 25 °C with spindle 31 at 60 rpm.

The curable coating composition may have a relatively long pot life. In one exemplary embodiment, the curable coating composition has a pot life of at least 5 days, preferably at least 7 days, more preferably at least 10 days, and more preferably at least 20 days, and including all ranges and subranges therebetween. The curable coating composition may have a longer pot life if not exposed to light, in particular UV light.

In one aspect of the present embodiments, the curable coating composition is capable of forming an opaque coating when cured. As used herein, "opaque" means lack of transparency or translucency, and a coating on a substrate is considered "opaque" when it sufficiently blocks the light from inside the substrate so that the light internally reflected in the substrate is not visible to human eyes.

The curable coating composition may be cured by irradiation of any light, including visible and invisible light such as UV and infrared. Preferably, the curable coating composition is curable by UV irradiation.

The cured coating may be solvent resistant. As used herein, "resistant" may mean the colorant in the cured coating does not leach out from the cured coating when the cured coating is exposed to a solvent. The solvent may be, for example, any solvents that may be used to clean or care eyeglasses, such as commercial lens cleaners, aqueous solution containing a surfactant, soapy water, isopropyl alcohol, and acetone.

The durability of the cured coating may be tested using an accelerated aging test in a Q-Lab Corporation Q-SUN test chamber, by irradiating light, such as UV, for a predetermined period of time. The Q-sun test includes placing samples having a cured coating in a Q-sun® Xe-3 xenon chamber, which reproduces full spectrum 20 sunlight, at a relative humidity of 20% (± 5%) and at a temperature of 23°C (± 5°C), and exposing their coated sides to the light for a predetermined time, such as 40 hours or 80 hours. Preferably, the adhesion of the cured coating will not be lost after Q-SUN exposure for 40 hours, more preferably for 80 hours.

The cured coating may have adhesiveness to various substrates. The substrate is preferably an organic substrate, including thermoset substrates and thermoplastic substrates. In particular, the substrate may be a cast finished single vision (FSV) organic lens having a concave side and a convex side. The substrate may have an organic abrasion resistant hard coating, an inorganic abrasion resistant hard coating, or both. The substrate may also have an anti-reflective coating on one or both main surfaces of the substrate.

In one exemplary embodiment, the substrate is a lens suitably used for eyeglasses, including prescription glasses and non-prescription glasses. In one embodiment, the substrate is a lens for correction of myopia or hyperopia. In another embodiment, the substrate is a concave lens, in particular a lens for correction of myopia. In one embodiment, the substrate is a lens for correction of myopia that displays myopia rings produced due to internal reflections of light on its peripheral edge.

Non-limiting examples of thermoset substrates that may be used for glasses include CR-39® (allyl diglycol carbonate), Trivex® (R.I.=1.53), mid index (R.I.= 1.56), MR-8 (R.I.=1.60), Thin & Lite ™ 1.67, and High Index 1.74 lenses. Non-limiting examples of thermoplastic substrates that may be used for glasses include polycarbonate.

A second embodiment is related to a method for preparing the curable coating composition described above.

To prepare the curable coating composition, all components of the curable coating composition described above are mixed altogether to form a 1K curable coating composition. The order of mixing the components is not particularly limited.

In one exemplary embodiment, all monomers, including the epoxyalkoxysilane, the acrylate, and vinyl based monomers (if any), may be first mixed in a mixing cup. The photoinitiator may then be added to the mixing cup. After closing the lid on the mixing cup, these components may be mixed until a homogenous mixture is obtained. The mixing time may be, for example, at least for 3 minutes, or at least for 6 minutes, and the mixing speed may be 300 to 3,000 rpm. The colorant may then be added to the homogenous mixture, and the mixture may be further mixed until the colorant is homogenously mixed. The mixing time after addition of the colorant may be, for example, at least for 3 minutes, or at least for 6 minutes, and the mixing speed may be 300 to 3,000 rpm.

The obtained homogenous mixture including the epoxyalkoxysilane, the photoinitiator, the colorant, the acrylate, and optionally the vinyl based monomer, may be kept in a sealed, UV light resistant container until ready for use to prevent premature exposure to atmospheric moisture or light.

A third embodiment is related to use of the curable coating composition described above to coat a substrate, or a method for coating a substrate.

In one aspect of the present embodiments, the substrate may be an organic substrate, including thermoset substrates and thermoplastic substrates. The thermoset substrates and thermoplastic substrates described above may be used. The substrate may have reflective index ranging from 1.50 to 1.74.

In one exemplary embodiment, the curable coating composition is applied onto a lens for eyeglasses, including prescription glasses and non-prescription glasses. Preferably, the curable coating composition is applied onto a peripheral edge of the lens for eyeglasses. The lens may be a lens for correction of myopia or hyperopia, preferably a lens for correction of myopia, in particular a lens for correction of myopia that displays myopia rings on its peripheral edge produced due to internal reflections of light.

Prior to application of the curable coating composition, the substrate may be edged to a desired shape. When the substrate is a lens for eyeglasses, the substrate may be edged to the shape of frames. The edge of the substrate may have a bevel. Prior to application of the curable coating composition, the edged lens surface may also be wiped with an appropriate cloth and solvent such as isopropyl alcohol to avoid any surface contamination. The substrate may be thoroughly dried prior to application of the curable coating composition.

The curable coating composition may be applied onto any part of the substrate. Preferably, the curable coating composition is applied only to the edges of the substrate. To uniformly apply the curable coating composition to the edges of the substrate, the substrate may be mounted on a rotator, and an applicator containing the curable coating composition may be pressed against the edge of the substrate while the substrate is rotating.

After the curable coating composition is applied onto the substrate, the curable composition is cured with irradiation of light, such as UV. During the curing, the substrate may be rotated so that the coating composition is uniformly cured. The curing process may take from about 10 seconds to about 1 hour, preferably from about 30 seconds to about 45 minutes, more preferably about 10 seconds minutes to about 25 minutes, depending on the UV source used.

To irradiate the curable coating composition applied on the substrate, any UV light sources may be used to cure the coating composition, and any light guides may be used to irradiate the desired area of the substrate. For example, UV light guides can directly irradiate the edge of the substrate and may be used to adequately cure the coating composition. The number of light guides may be determined based on the shape of the substrate and/or the region of the substrate at which the coating composition is applied.

An exemplary process for coating a substrate with the curable coating composition is as follows. First, the substrate (such as a lens) may be edged, and the edged substrate may be mounted on a rotator. The edge of the substrate may be cleaned with isopropyl alcohol (IPA) to clean the surface, and dried. Then, the curable coating composition may be applied onto the edge of the substrate to form a first coat. The first coat may be formed by rotating the substrate, for example, three times. The coating composition applied to the edge of the substrate may be cured while rotating the substrate. After the coating composition is cured, the overflow coating may be removed by using a lint free cloth. If necessary, a second coat may be formed on the first coat by repeating the same process for forming the first coat. After formation of the cured coating, optionally, a protective layer covering the main surfaces of the substrate (lens) may be removed, and then the substrate may be mounted on a frame, such as a frame of eyeglasses.

A fourth embodiment is related to a method for hiding myopic rings that appear on a peripheral edge of a myopic lens.

When the substrate is a concave lens, such as a lens for correction of myopia, ring marks produced due to internal reflections of light may be observed at the edge of the lens. By applying the curable coating composition on the edge of the lens and curing the composition to form an opaque cured coating on the edge of the lens, those myopic rings may be masked and appearance of the lens can be improved without changing visibility of the lens.

In one preferred embodiment, the curable coating composition is applied only to the edge of the lens so that the cured coating is formed only on the edge of the lens.

The colorant in the curable coating composition may be selected so that the cured coating has a color that matches or compliments the frame color or the lens color for cosmetic advantages.

A fifth embodiment is related to a substrate having a cured coating. The cured coating can be obtained by curing the curable coating composition described above.

In one aspect of the present embodiments, the substrate is a concave lens, for example a lens for correction of myopia.

In one aspect, the cured coating has a color that matches or compliments the color of the substrate.

In one aspect, the cured coating is formed only on the edge of the substrate.

A sixth embodiment is related to eyeglasses having lenses with an edge coated with the cured composition. The cured composition can be obtained by curing the curable coating composition described above.

The eyeglasses may be non-prescription glasses or prescription glasses. The eyeglasses may have concave lenses. In one aspect, the eyeglasses are prescription glasses with ophthalmic lenses for correction of myopia.

In one aspect, the cured coating is formed only on the edge of the substrate. The frame may expose at least a part of the edge of the lenses.

A seventh embodiment is related to a kit for coating a substrate. The kit may include a container in which the curable coating composition is contained. The container may have an applicator portion made of, for example, a fabric, so that the curable coating composition is directly applied onto a desired area through the applicator portion. The container having the applicator portion may also have a tightly closable cap to cover the applicator portion so that the curable coating composition is sealed in the container when the cap is closed.

The curable coating composition may be a 1K composition that does not require mixing of multiple components just prior to use. As such, the kit may have only one container containing the curable coating composition so that the curable coating composition in the container may be directly applied to a desired area.

The kit may also include an instruction instructing to shake the container well before each use.

### EXAMPLES

The following examples are illustrative and do not limit in any way the present embodiments.

In the following experiments, cast finished single vision (FSV) thermoset and thermoplastic organic lens materials were used as a substrate. Prior to coating the lenses with a coating composition, an anti-reflective Crizal™ coating and a protective layer were applied on the outermost surfaces of the substrate. Prior to applying a coating composition, the lenses were edged to a round shape for adhesion testing, and to the shape of frames with a bevel for cosmetic inspections inside and outside of the frames. The edged lens surface was wiped using a lint free cloth and isopropyl alcohol (IPA) to remove any surface contamination and allowed to dry prior to coating.

The materials of these lenses include CR-39® (allyl diglycol carbonate), polycarbonate, Trivex (R.I. 1.53), mid index (R.I. 1.56), MR-8 (R.I. 1.60), Thin & Lite™ 1.67, and High Index 1.74 lenses. These lenses were used as substrates in all experiments described below.

In the following experiments, coating compositions (formulations) were prepared by the following process. All monomers were added to a FlackTek polypropylene (PP Max 71ml) mixing cup on a laboratory balance having a capacity of >200 grams and a sensitivity of 0.01 gram or greater. Photoinitiators were added using an analytical balance having a capacity of >100 grams and a sensitivity of 0.001 grams or greater. After closing the lid on the cup, these components were mixed in a FlackTek DAC 150.1 speed mixer with a FlackTek Mx 40 holder for 3 minutes. The initial mixing speed was increased from 300 rpm to 2,500 rpm over the course of 10 seconds, held at 2500 rpm for 2.5 minutes, and then the mixing speed was decreased to 300 rpm over the course of 10 seconds prior to the mixer automatically stopping as the programmed time expires. The solution was then inspected for homogeneity. If the mixture was not homogeneous, the mixture was mixed in the FlackTek mixer for an additional 2 minutes at 2,500 rpm increasing and decreasing the speed from and to 300 rpm as performed originally. Mixing was repeated until the solution was homogeneous. Carbon black was then weighed on an analytical balance having a capacity of >100 grams and a sensitivity of 0.001 grams or greater in a weigh boat and transferred to the premixed monomers and the photoinitiators. The carbon black was dispersed using the FlackTek mixer increasing the speed from 300 rpm to 2,500 rpm over the course of 10 seconds, holding at 2,500 rpm for 2 minutes, and then the mixing speed was decreased to 300 rpm over the course of 10 seconds prior to the mixer automatically stopping as the programmed time of 3 minutes expires. This process was repeated two additional times for 3 minutes to ensure homogenous mixing of the carbon black.

In the following experiments, a coating composition was applied to a substrate (lens) by the following process. The homogenous mixture prepared by the process described above is transferred to a 100 ml ink dauber using a dropper pipet. A fabric covered cap is then snapped on and a screw cap is screwed on tightly. Since the carbon black can phase separate after sitting for extended periods, the dauber should be shaken vigorously for a few seconds prior to each use. The pot-life of the coating composition is at least two weeks in the dauber at room temperature if not exposed to UV light.

An edged lens was placed in a lens rotator using a rubber block from edging to secure it into position. The motor was turned on and the speed of rotation was regulated based on the preference of the person applying the coating. While rotating, the dauber containing a coating composition was lightly pressed against the lens edge to dispense the coating composition in a uniform manner. The lens was allowed to make a minimum of three rotations during coating application to insure adequate coating coverage. The number of rotations depends on the dispense pressure and the speed of rotation.

In the following experiments, an American Ultraviolet Spectrum 100 UV Spot Cure equipped with a dual fiber optic light guide was used to cure the coating composition applied on the outer edge of the lens. The Spectrum 100 Spot Cure utilizes a shutter system to regulate exposure time. The UV lamp remains on inside the housing and the UV exposure time is regulated by the opening and closing of a shutter, which occurs automatically. The opening and closing times of the shutter are easily adjusted and set by the operator. UV light guides were directed at the edge of the lens on opposite sides with one directed at the edge and the front side of the bevel and the other at the edge and the back side of the bevel to adequately cure the coating composition on both sides of the bevel and the edges. The UV light guides were positioned so that the distance from the tip of the UV light guide to the lens is between 30 mm and 40 mm. The distance varies based on the shape of the lens. Since the UV light guides were only exposing two small points on the lens edge while rotating, those points were allowed to cool while not being exposed. As a precaution, the shutter was set to close for 10 seconds after every 60 seconds of exposure time to allow the lens and the light guide to cool.

### Experiment 1 - Preliminary Formulations

Glycidoxypropyltrimethoxysilane (GLYMO), a cationic photoinitiator (triarylsulfonium hexafluoroantimonate salts, mixed; triarylsulfonium hexafluorophosphate salts, mixed; or a mixture of these salts), and carbon black (REGAL® 400 Carbon Black, sold by Cabot Corporation) were mixed to prepare preliminary formulations. The amounts (in % by mass) of each component are shown in Table 1.

Each formulation was applied to an edge of a CR-39 substrate and cured with UV irradiation for 2 minutes to form an edge coating. In this experiment, a Fusion Systems UV conveyor with an H+ bulb was used to cure each formulation until the edge becomes tack free.

To test resistance of the cured edge coatings to various solvents, the edge coatings were exposed to a soapy water, isopropyl alcohol (IPA), and acetone to see if the carbon black leaches out from the edge coatings. The edge coatings were wiped with a lint free cloth containing each solvent for three to five seconds at least twice, and observed if the carbon blacks had transferred to the lint free cloth.

The visual appearance of the cured edge coatings were evaluated by experienced researchers.

**Table 1**

| | **Example 1** | **Example 2** |
|---|---|---|
| GLYMO | 74.05 | 66.27 |
| Cationic photoinitiator | 9.751 | 8.727 |
| Carbon Black | 16.194 | 25.000 |
| Total | 100.00 | 100.00 |
| Time to tack free H+ bulb | 30 seconds | 30 seconds |
| Total time of cure | 2 minutes | 2 minutes |

| | Resistance Testing | |
|---|---|---|
| Soap/H2O | No leaching | No leaching |
| IPA | No leaching | No leaching |
| Acetone | No leaching | No leaching |
| Visual Cosmetics | Very Nice | Fair |
| Viscosity | low | very high |

Each formulation was also applied on a polycarbonate substrate. The viscosity of the formulation of example 1 was very low to coat an edge of a polycarbonate substrate, requiring two coats for adequate coverage. The formulation of example 1 also exhibited poor adhesion to a polycarbonate substrate.

### Experiment 2 - Addition of Acrylate to Preliminary Formulations

Glycidoxypropyltrimethoxysilane (GLYMO), a cationic photoinitiator (triarylsulfonium hexafluoroantimonate salts, mixed; triarylsulfonium hexafluorophosphate salts, mixed; or a mixture of these salts), carbon black (REGAL® 400 Carbon Black, sold by Cabot Corporation), a polyester acrylate oligomer, and a free-radical photoinitiator (Darocur® 1173; and/or Irgacure® 819) were mixed to prepare the formulations of Examples 3, 4, and 5 in the amounts (in mass%) shown in Table 2 below. The polyester acrylate oligomer can be cured by the free-radical photoinitiator.

Each formulation was applied to an edge of a CR-39 substrate and a polycarbonate (PC) substrate, and cured with UV irradiation to form an edge coating.

To test adhesion of the cured edge coatings to the substrates, Q-SUN accelerated aging test was conducted with Q-SUN Test Chamber manufactured by Q-Lab Corporation, Q-sun® Xe-3 xenon chamber, for 40 hours or 80 hours. In Table 2 below, the Q-SUN adhesion results of 0 and 1 are passing and 2 through 5 are failures with 5 showing the greatest coating loss in testing.

**Table 2**

| | **Example 3** | | | **Example 4** | | | **Example 5** | | |
|---|---|---|---|---|---|---|---|---|---|
| GLYMO | 56.00 | | | 46.00 | | | 42.00 | | |
| Polyester acrylate oligomer | 20.00 | | | 30.00 | | | 35.00 | | |
| Triarylsulfoniumhexafluoroantimonate | 5.46 | | | 4.485 | | | 4.095 | | |
| Triarylsulfoniumhexafluorophosphate | 1.82 | | | 1.495 | | | 1.365 | | |
| Darocur 1173 | 0.40 | | | 0.600 | | | 0.700 | | |
| Irgacure 819 | 0.100 | | | 0.150 | | | 0.175 | | |
| Carbon Black | 16.220 | | | 17.270 | | | 16.660 | | |
| Total | 100.00 | | | 100.00 | | | 100.00 | | |

| | Adhesion Testing | | | | | | | | |
|---|---|---|---|---|---|---|---|---|---|
| CR-39 Q-SUN before | 1 | 2 | 0 | 0 | 0 | n/a | 0 | 3 | n/a |
| CR-39 Q-SUN 40 hrs. | 0 | 0 | 2 | 0 | 0 | n/a | 0 | 0 | n/a |
| CR-39 Q-SUN 80 hrs. | 0 | 0 | 0 | 0 | 0 | n/a | 0 | 0 | n/a |
| | | | | | | | | | |
| PC Q-SUN before | 0 | 2 | 0 | 5 | 5 | n/a | 5 | 5 | n/a |
| PC Q-SUN 40 hrs. | 1 | 3 | 4 | 3 | 3 | n/a | 4 | 3 | n/a |
| PC Q-SUN 80 hrs. | 0 | 0 | 0 | 4 | 2 | n/a | 5 | 3 | n/a |

The adhesion testing, both before and after the Q-SUN accelerated aging, gave mixed results.

### Experiment 3 - Resistance of Coatings of Preliminary Formulations Plus Acrylate

The results of experiment 2 show that addition of a polyester acrylate oligomer to the preliminary formulation may improve adhesion of the edge coating to the substrate.

Formulations of examples 6 and 7 were prepared by mixing the components in the amounts (in mass%) shown in Table 3 below.

Each formulation was applied to an edge of a CR-39 substrate, a polycarbonate (PC) substrate, a Thin & Lite™ 1.67 substrate, and a High Index 1.74 substrate, and cured with UV irradiation to form an edge coating.

To test adhesion of the cured edge coatings to each substrate, Q-SUN accelerated aging test was conducted for 80 hours.

To test resistance of the edge coating to various solvents, the edge coating prepared from the formulation including a polyester acrylate oligomer was exposed to a soapy water, isopropyl alcohol (IPA), and acetone to see if the carbon black leaches out from the cured edge coating, by the same process employed in experiment 1.

**Table 3**

| | **Example 6** | **Example 7** |
|---|---|---|
| GLYMO | 56.00 | 74.05 |
| Polyester acrylate oligomer | 20.00 | --- |
| Triarylsulfoniumhexafluoroantimonate | 5.46 | 7.32 |
| Triarylsulfoniumhexafluorophosphate | 1.82 | 2.44 |
| Darocur 1173 | 0.40 | --- |
| Irgacure 819 | 0.10 | --- |
| Carbon Black | 16.22 | 16.19 |
| Total | 100.00 | 100.00 |

| | Adhesion Testing | |
|---|---|---|
| CR-39 Q-SUN 80 hrs. | Pass | Fail |
| PC Q-SUN 80 hrs. | Pass | Fail |
| 1.67 Q-SUN 80 hrs. | Fail | Fail |
| 1.74 Q-SUN 80 hrs. | Pass | Fail |

| | Resistance Testing | |
|---|---|---|
| Soap/H2O | No leaching | No leaching |
| IPA | No leaching | No leaching |
| Acetone | Leaching | No leaching |

While adhesion of the cured edge coating to various substrates improved by addition of a polyester acrylate oligomer, the carbon black leached out from the cured edge coating when the edge coating was exposed to acetone.

### Experiment 4 - Addition of Different Acrylates to Preliminary Formulations

The results of experiment 2 show that addition of a polyester acrylate oligomer to the preliminary formulation may improve adhesion of the edge coating to the substrate.

Formulations of examples 8, 9, and 10 were prepared by using phenoxyethyl acrylate and 1,6-hexanediol diacrylate in addition to or as an alternative to the polyester acrylate oligomer. The amounts (in mass%) of the components of these examples are shown in Table 4 below.

Each formulation was applied to an edge of a CR-39 substrate and a polycarbonate (PC) substrate, and cured with UV irradiation to form an edge coating.

The adhesion of the cured edge coatings to each substrate prior to Q-SUN accelerated aging test was evaluated. The scores 0 and 1 are passing and 2 through 5 are failures with 5 showing the greatest coating loss.

To test resistance of the edge coating to various solvents, the edge coatings were exposed to a soapy water, isopropyl alcohol (IPA), and acetone to see if the carbon black leaches out from the edge coatings, by the same process employed in experiment 1.

**Table 4**

| | **Example 8** | | **Example 9** | | **Example 10** | |
|---|---|---|---|---|---|---|
| BYK 9076 (Surfactant) | 6.400 | | 8.000 | | 0.383 | |
| Carbon black | 16.000 | | 20.000 | | 16.642 | |
| GLYMO | 64.000 | | 60.000 | | 48.570 | |
| Phenoxyethyl acrylate | 5.000 | | --- | | --- | |
| 1,6-hexanediol diacrylate | --- | | --- | | 10.230 | |
| Polyester acrylate oligomer | --- | | 4.050 | | 17.400 | |
| Darocur 1173 | 0.120 | | 0.120 | | 0.334 | |
| Irgacure 819 | 0.030 | | 0.030 | | 0.084 | |
| Triarylsulfoniumhexafluoroantimonate | 6.338 | | 5.850 | | 4.757 | |
| Triarylsulfoniumhexafluorophosphate | 3.113 | | 1.950 | | 1.586 | |
| Total | 100.000 | | 100.000 | | 99.986 | |
| Viscosity | moderate | | high | | moderate | |
| Lens Material | CR-39 | PC | CR-39 | PC | CR-39 | PC |

| | Adhesion Testing | | | | | |
|---|---|---|---|---|---|---|
| Dry (initial) Adhesion | 0 | 0 | 5 | 0 | 2 | 0 |

| | Resistance Testing | | | | | |
|---|---|---|---|---|---|---|
| Soap/H2O | OK | OK | FAIR | POOR | POOR | OK |
| IPA | OK | OK | FAIR | POOR | OK | OK |
| Acetone | OK | POOR | POOR | POOR | FAIR | FAIR |

As shown in Table 4, the edge coatings of examples 8, 9, and 10, in particular the edge coatings of examples 9 and 10, did not exhibit desirable resistance to the solvents. The carbon black may be leached out from the edge coating because the density of crosslink structures of the acrylates in these formulations is not sufficiently high to retain the carbon black in the cured edge coating.

### Experiment 5 - Addition of Multifucntional Acrylate to Preliminary Formulations

The results of experiment 4 show that addition of phenoxyethyl acrylate, 1,6-hexanediol diacrylate, and/or polyester acrylate oligomer to the preliminary formulation does not sufficiently improve resistance of the cured edge coating to various solvents.

Formulations of examples 12 and 13 were prepared by using dipentaerythritolpentaacrylate in the amount (in mass%) shown in Table 5. For comparison, Table 5 also shows a primary formulation (example 11). The composition of example 11 is substantially similar to that of example 1.

Each formulation was applied to an edge of a CR-39 substrate, a polycarbonate (PC) substrate, and a Thin & Lite™ 1.67 substrate, and cured with UV irradiation to form an edge coating.

To test adhesion of the cured edge coatings to each substrate, Q-SUN accelerated aging test was conducted for 40 hours or 80 hours.

**Table 5**

| | **Example 11** | | | **Example 12** | | | **Example 13** | | |
|---|---|---|---|---|---|---|---|---|---|
| GLYMO | 74.05 | | | 65.00 | | | 70.00 | | |
| Dipentaerythritolpentaacryl ate | --- | | | 10.00 | | | 5.00 | | |
| Triarylsulfonium hexafluoroantimonate | 7.31 | | | 6.338 | | | 6.825 | | |
| Triarylsulfonium hexafluorophosphate | 2.44 | | | 2.112 | | | 2.275 | | |
| Darocure 1173 | --- | | | 0.400 | | | 0.200 | | |
| Irgacure 819 | --- | | | 0.100 | | | 0.050 | | |
| Carbon Black | 16.19 | | | 16.050 | | | 15.650 | | |
| Total | 100.00 | | | 100.00 | | | 100.00 | | |
| | Adhesion Testing | | | | | | | | |
| Lens Material | CR-39 | PC | 1.67 | CR-39 | PC | 1.67 | CR-39 | PC | 1.67 |
| Q-SUN before | N.T. | N.T. | N.T. | 3/2 | 0/0 | N.T. | 3/3 | 2/5 | N.T. |
| Q-SUN 40 hrs. | N.T. | N.T. | N.T. | 0/0 | 0/0 | N.T. | 2/0 | 0/2 | N.T. |
| Q-SUN 80 hrs. | Fail | Fail | N.T. | 0/0 (Pass) | 0/0 (Pass) | Pass | 0/0 (Pass) | 5/4 (Fail) | N.T. |

As shown in Table 5, addition of 10% by mass of dipentaerythritolpentaacrylate resulted in robust adhesion of the edge coating to the polycarbonate substrate, even after accelerated Q-SUN aging. The poor dry adhesion to the CR-39 substrate and good adhesion after further UV exposure in the Q-SUN testing may indicate that this particular formulation requires additional UV exposure time for a CR-39 substrate as a result of reducing the amount of GLYMO, which may exhibit good adhesion to the CR-39 substrate upon curing.

Resistance of the edge coatings prepared from formulations containing dipentaerythritolpentaacrylate was also tested. Cured edge coatings were prepared by applying the formulations shown in Table 6 below to an edge of a CR-39 substrate and PC substrate, and cured with UV irradiation to form an edge coating. The edge coatings were exposed to a soapy water, isopropyl alcohol (IPA), and acetone to see if the carbon black leaches out from the edge coatings, by the same process employed in experiment 1. The composition of example 14 is substantially similar to that of example 6 except that an urethaneacrylate blend was used in place of polyester acrylate oligomer. The compositions of examples 15, 16, and 17 are substantially similar to those of examples 11, 12, and 13 prepared above.

**Table 6**

| | **Example 14** | | **Example 15** | | **Example 16** | | **Example 17** | |
|---|---|---|---|---|---|---|---|---|
| GLYMO | 56.00 | | 74.05 | | 65.00 | | 70.00 | |
| Urethaneacrylate blend | 20.00 | | --- | | --- | | --- | |
| Dipenterythritol pentaacrylate | --- | | --- | | 10.00 | | 5.00 | |
| Triarylsulfoniumhexafluoroantimona te | 5.46 | | 7.31 | | 6.34 | | 6.83 | |
| Triarylsulfoniumhexafluorophosphat e | 1.82 | | 2.44 | | 2.11 | | 2.28 | |
| Darocure 1173 | 0.40 | | --- | | 0.40 | | 0.20 | |
| Irgacure 819 | 0.10 | | --- | | 0.10 | | 0.05 | |
| Carbon Black | 16.22 | | 16.19 | | 16.05 | | 15.65 | |
| Total | 100.00 | | 100.00 | | 100.00 | | 100.00 | |

| | Adhesion Testing | | | | | | | |
|---|---|---|---|---|---|---|---|---|
| Lens Material | CR-39 | PC | CR-39 | PC | CR-39 | PC | CR-39 | PC |
| Soap/H2O | Fail | Pass | Pass | Pass | Pass | Pass | Pass | Pass |
| IPA | Fail | Fail | Pass | Pass | Pass | Pass | Pass | Pass |
| Acetone | Fail | Fail | Pass | Fail | Pass | Pass | Pass | Pass |

The cured edge coatings prepared from formulations containing dipentaerythritol pentaacrylate exhibited good resistance to various solvents.

### Experiment 6 - Addition of Vinyl Monomer to Formulation

To a formulation containing the components used in examples 12, 13, 16, and 17, vinyltrimethoxysilane was added to prepare formulations of examples 18, 19, 20, and 21. The amounts (in mass%) of each component in these formulations are shown in Table 7 below.

Each formulation was applied to an edge of a CR-39 substrate, a polycarbonate (PC) substrate, a MR-8 (R.I. 1.60) substrate, a Thin & Lite™ 1.67 substrate, a High Index 1.74 substrate, a R.I.= 1.54 substrate, and a mid-index (R.I. 1.56) substrate, and cured with UV irradiation to form an edge coating.

To test adhesion of the cured edge coatings to each substrate, Q-SUN accelerated aging test was conducted for 80 hours.

To test resistance of the edge coating to various solvents, the edge coatings prepared from each formulation were exposed to a soapy water, isopropyl alcohol (IPA), and acetone to see if the carbon black leaches out from the edge coatings, by the same process employed in experiment 1.

The substrates with the cured edge coating were also mounted to and unmounted from a full rimmed acetate frame to test durability of the edge coating. The edge coatings before and after the mounting/unmounting were inspected by experts to determine if the edge coating chipped by the mounting/unmounting.

**Table 7**

| | **Example 18** | | | **Example 19** | | | **Example 20** | | | **Example 21** | | |
|---|---|---|---|---|---|---|---|---|---|---|---|---|
| GLYMO | 52.67 | | | 50.65 | | | 46.60 | | | 41.42 | | |
| Dipenterythritol pentaacrylate | 9.61 | | | 9.21 | | | 9.32 | | | 9.20 | | |
| Vinyltrimethoxysilane | 9.61 | | | 13.81 | | | 18.64 | | | 23.01 | | |
| Triarylsulfonium hexafluoroantimonate | 6.07 | | | 4.49 | | | 4.55 | | | 4.04 | | |
| Triarylsulfonium hexafluorophosphate | 2.02 | | | 1.50 | | | 1.52 | | | 1.35 | | |
| Darocur 1173 | 0.64 | | | 1.54 | | | 0.60 | | | 2.06 | | |
| Irgacure 819 | 0.16 | | | 0.38 | | | 0.15 | | | 0.52 | | |
| Carbon Black | 19.22 | | | 18.42 | | | 18.64 | | | 18.41 | | |
| Total | 100.00 | | | 100.00 | | | 100.00 | | | 100.00 | | |

| | Durability Testing | | | | | | | | | | | |
|---|---|---|---|---|---|---|---|---|---|---|---|---|
| Mounting (chipping) | Minor chipping | | | Minor chipping | | | Minor chipping | | | No chipping | | |
| | Adhesion Testing | | | | | | | | | | | |
| Lens material | CR-39 | PC | 1.60 | CR-39 | PC | 1.60 | CR-39 | PC | 1.60 | CR-39 | PC | 1.60 |
| Q-SUN 80 hrs | Pass | Pass | Pass | Pass | Pass | Pass | Pass | Pass | Pass | Pass | Pass | Pass |
| Lens material | 1.67 | 1.74 | 1.54 | 1.67 | 1.74 | 1.54 | 1.67 | 1.74 | 1.54 | 1.67 | 1.74 | 1.54 |
| Q-SUN 80 hrs | Pass | N.T. | N.T. | Pass | N.T. | N.T. | Pass | N.T. | N.T. | Pass | Pass | Pass |
| Lens material | 1.56 | | | 1.56 | | | 1.56 | | | 1.56 | | |
| Q-SUN 80 hrs | N.T. | | | N.T. | | | N.T. | | | Pass | | |

| | Resistance Testing | | | | | | | | | | | |
|---|---|---|---|---|---|---|---|---|---|---|---|---|
| Soap/H2O | Pass | | | Pass | | | Pass | | | Pass | | |
| IPA | Pass | | | Pass | | | Pass | | | Pass | | |
| Acetone | Pass | | | Pass | | | Pass | | | Pass | | |

As shown in Table 7 above, the cured edge coating prepared in example 21 exhibited no chipping by mounting and unmounting of the lens, strongly adhered to all kinds of substrates, and did not exhibit leach out of carbon black when exposed to various solvents. In contrast, although the edge coatings prepared in examples 18, 19, and 20 exhibited desirable adhesion to various substrates and resistance to various solvents, these edge coatings chipped during mounting/unmounting to a frame.

To further test durability of a cured edge coating prepared from formulations containing each components in different amounts, formulations of examples 22 and 23 shown in Table 8 were prepared.

Each formulation was applied to an edge of a polycarbonate (PC) substrate, a MR-8 (R.I. 1.60) substrate, a Thin & Lite™ 1.67 substrate, and cured with UV irradiation to form an edge coating. The obtained lenses with the cured edge coating were mounted to and unmounted from a full rimmed acetate frame, and chipping of the edge coating outside and inside of the frames was inspected by the method described above.

**Table 8**

| | **Example 22** | **Example 23** |
|---|---|---|
| GLYMO | 46.05 | 45.91 |
| Dipentaerythritolpentaacrylate | 9.21 | 9.18 |
| Poleyster acrylate oligomer | 9.21 | --- |
| Vinyltrimethoxysilane | 9.21 | 18.37 |
| Triarylsulfoniumhexafluoroantimonate | 4.49 | 4.48 |
| Triarylsulfoniumhexafluorophosphate | 1.497 | 1.492 |
| Darocur 1173 | 1.533 | 1.763 |
| Irgacure 819 | 0.383 | 0.441 |
| Carbon Black | 18.420 | 18.365 |
| Total | 100.00 | 100.00 |
| Edge coverage outside of frames (all three substrates) | Fail | Pass |
| Edge coverage in frames (all three substrates) | Fail - chipping | Fail - chipping |

The edge coatings prepared in examples 22 and 23 chipped by mounting/unmounting to a frame, regardless of the material of the substrate.

### Experiment 7 - Cationic Photoinitiator Concentration

In experiment 1, preliminary formulations including glycidoxypropyltrimethoxysilane (GLYMO), a cationic photoinitiator, and carbon black were prepared. To determine the amount of a cationic photoinitiator to form a cured coating that can properly hold the carbon black inside the coating, varying amounts (in mass%) of cationic photoinitiator(s) shown in Table 9 below were added to a Base Coating including 80.00 mass% of GLYMO and 20.00 mass% of carbon black, and cured with UV irradiation.

The resulting cured coatings were exposed to a soapy water, isopropyl alcohol (IPA), and acetone to see if the carbon black leaches out from the edge coatings, by the process employed in experiment 1. The results are shown in Table 9.

**Table 9**

| | **Example 24** | **Example 25** | **Example 26** | **Example 27** |
|---|---|---|---|---|
| Base Coating | 98.43 | 96.90 | 95.42 | 93.98 |
| Triarylsulfoniumhexafluoroantimonate | 1.26 | 2.48 | 3.35 | 4.52 |
| Triarylsulfoniumhexafluorophosphate | 0.31 | 0.62 | 1.15 | 1.51 |
| Total | 100.00 | 100.00 | 100.00 | 100.00 |
| Soap/H2O | 50% ctg loss | 10% ctg loss | minor leaching | No leaching |
| IPA resistance | Poor ctg loss/excess | poor leaching | minor leaching | No leaching |
| Acetone resistance | Poor ctg loss/excess | leaching | No leaching | No leaching |

Based on the results shown in Table 9, the desirable amount of cationic photoinitiator may be 9% to 13% by mass of the weight amount of GLYMO.

### Experiment 8 - Properties of Coating

In experiment 6, an edge coating prepared in example 21 exhibited desirable durability, adhesion, and resistance. To further examine properties of an edge coating prepared from the formulation of example 21, the formulation of example 21 was applied to an edge of a substrate of a lens having refractive index of 1.6, a lens having refractive index of 1.67, and a polycarbonate lens, and cured by UV radiation.

A Basic test and a durability test were performed on the cured edge coatings. The results are shown in Table 10 below.

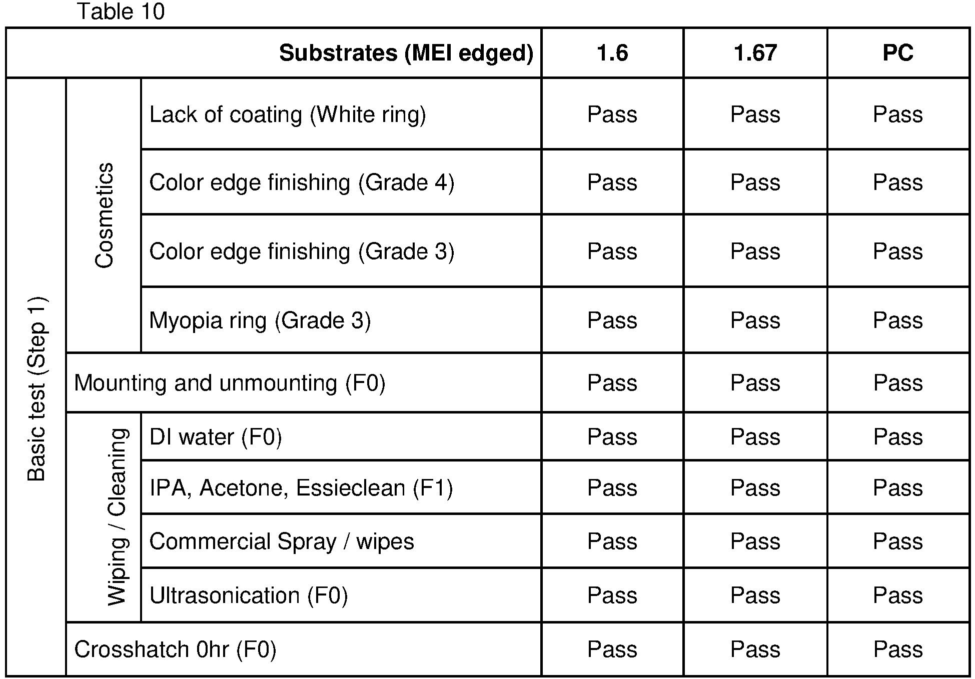

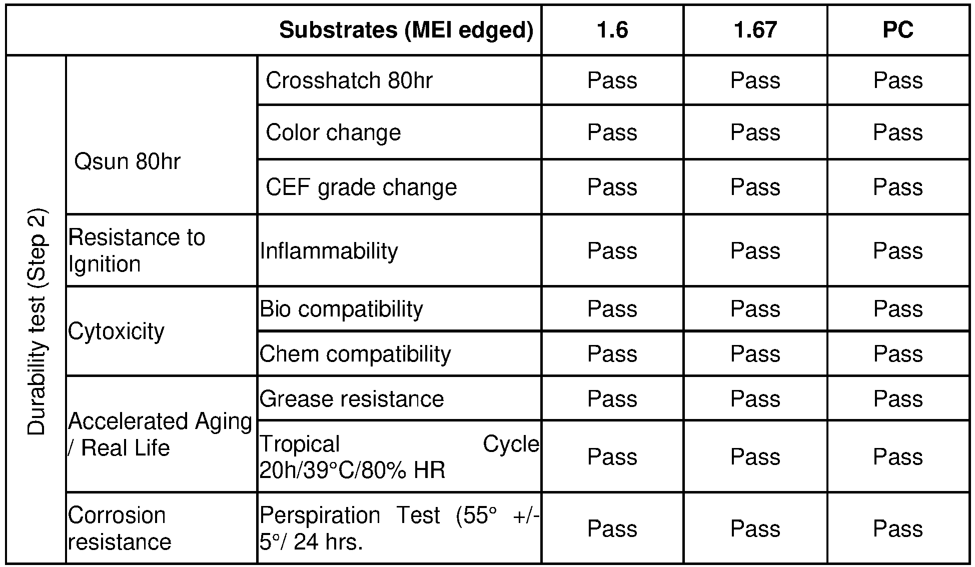

Obviously, numerous modifications and variations of the present embodiments are possible in light of the above disclosures. It is therefore to be understood that within the scope of the appended claims, the embodiments may be practiced otherwise than as specifically described herein.

## Claims

1. A coating composition, comprising:
an epoxyalkoxysilane;
a photoinitiator;
a colorant; and
an acrylate.

2. The coating composition of claim 1, wherein the colorant comprises carbon black.

3. The coating composition of claim 1, wherein the epoxyalkoxysilane comprises glycidoxypropyltrimethoxysilane.

4. The coating composition of claim 1, wherein the acrylate comprises dipentaerythritolpentaacrylate.

5. The coating composition of claim 1, wherein the coating composition further comprises a vinyl based monomer.

6. The coating composition of claim 5, wherein the vinyl based monomer comprises vinyltrimethoxysilane.

7. The coating composition of claim 1, wherein the photoinitiator comprises a cationic photoinitiator and a free radical photoinitiator.

8. The coating composition of claim 1, wherein the coating composition has a viscosity of from 20 to 40 cps at 25°C.

9. The coating composition of claim 1, wherein the coating composition is free of a solvent.

10. A method for coating an edge of a substrate, comprising:
applying the coating composition of claim 1 on an edge of a substrate, the edge connecting a first main surface and a second main surface of the substrate; and
curing the coating composition such that a coating is formed on the edge of the substrate.

11. The method of claim 10, wherein the substrate is an organic ophthalmic lens.

12. The method of claim 10, wherein the substrate comprises polycarbonate.

13. The method of claim 10, wherein the substrate has a refractive index of from 1.50 to 1.74.

14. A lens, comprising:
a substrate having a first main surface, a second main surface, and an edge connecting the first main surface and the second main surface; and
a coating formed on the edge of the substrate and obtained by curing the coating composition of claim 1.

15. The lens of claim 14, wherein the coating is opaque and is not formed on the first and second main surfaces.

## Amended claims

### Amended claims in accordance with Rule 137(2) EPC.

1. A coating composition, preferably that is a single-component composition, comprising, by weight, relative to its total weight, at least:
38% to 75% of an epoxyalkoxysilane;
5% to 15% of a photoinitiator;
5% to 30% of a colorant; and
5% to 20% of an acrylate.

2. The coating composition of claim 1, wherein the colorant comprises carbon black.

3. The coating composition of claim 1, wherein the epoxyalkoxysilane comprises glycidoxypropyltrimethoxysilane.

4. The coating composition of claim 1, wherein the acrylate comprises dipentaerythritolpentaacrylate.

5. The coating composition of claim 1, wherein the coating composition further comprises, by weight, relative to its total weight, from 5 to 15% of a vinyl based monomer.

6. The coating composition of claim 5, wherein the vinyl based monomer comprises vinyltrimethoxysilane.

7. The coating composition of claim 1, wherein the photoinitiator comprises a cationic photoinitiator and a free radical photoinitiator.

8. The coating composition of claim 1, wherein the coating composition has a viscosity of from 20 to 40 cps at 25°C.

9. The coating composition of claim 1, wherein the coating composition is free of a solvent.

10. A method for coating an edge of a substrate of an ophthalmic lens, comprising:
applying the coating composition of claim 1 on an edge of a substrate, the edge connecting a first main surface and a second main surface of the substrate; and
curing the coating composition such that a coating is formed on the edge of the substrate.

11. The method of claim 10, wherein the substrate is an organic ophthalmic lens.

12. The method of claim 10, wherein the substrate comprises polycarbonate.

13. The method of claim 10, wherein the substrate has a refractive index of from 1.50 to 1.74.

14. A lens, comprising:
a substrate having a first main surface, a second main surface, and an edge connecting the first main surface and the second main surface; and
a coating formed on the edge of the substrate and obtained by curing the coating composition of claim 1.

15. The lens of claim 14, wherein the coating is opaque and is not formed on the first and second main surfaces.
